Europäisches Patentamt

European Patent Office

Office européen des brevets

(19)

(11) Veröffentlichungsnummer: **0 099 506**

**A1**

(12)  # EUROPÄISCHE PATENTANMELDUNG

(21) Anmeldenummer: 83106520.6

(22) Anmeldetag: 04.07.83

(51) Int. Cl.³: **H 03 K 19/003**
**H 03 K 19/086**

(30) Priorität: 23.07.82 DE 3227651

(43) Veröffentlichungstag der Anmeldung:
01.02.84 Patentblatt 84/5

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Barré, Claude, Dipl.-Ing.
Implerstrasse 23
D-8000 München 70(DE)

(54) Integrierte Schaltungsanordnung in Stromumschaltetechnik mit einer Diode zur Pegelverschiebung.

(57) In Schaltungsanordnungen der Stromumschaltetechnik werden häufig zur Pegelverschiebung, insbesondere zur Signalpegelverschiebung, Dioden eingesetzt. Bei der Integration solcher Schaltungsanordnungen werden die Dioden im allgemeinen als Transistoren mit verbundenen Basis- und Kollektoranschlüssen ausgeführt. Ist durch einen Fertigungsfehler der Kollektorkontakt nicht angeschlossen, dann verringert sich die Störsicherheit durch eine erhöhte Pegelverschiebung, aber der Mangel wird bei der Überprüfung der Ausgangssignale der integrierten Schaltungsanordnung meistens nicht erkannt.

Durch die Einfügung eines Widerstands (R) zwischen die Basis und dem Kollektor eines als Diode geschalteten Transistors (D) wird im Fehlerfall die zusätzlich erzeugte Pegelverschiebung derart verstärkt, daß der Fehler bei der Prüfung der Ausgangssignale zuverlässig erkannt wird.

EP 0 099 506 A1

SIEMENS AKTIENGESELLSCHAFT
BERLIN UND MÜNCHEN

Unser Zeichen
VPA 82 P 1574 E

Integrierte Schaltungsanordnung in Stromumschaltetechnik mit einer Diode zur Pegelverschiebung

Die Erfindung bezieht sich auf eine integrierte Schaltungsanordnung nach dem Oberbegriff des Patentanspruchs.

Die Prüfung integrierter Schaltungsanordnungen der binären sequentiellen und nichtsequentiellen Logik zur Ausscheidung mangelhafter Exemplare erfolgt durch das Anlegen geeigneter Bitmuster bzw. Bitfolgen an die Eingangsanschlüsse und durch die Beobachtung der sich ergebenden Ausgangssignale. Es können jedoch interne Schaltungsfehler vorliegen, die auf diese Weise nicht oder nur sehr schwer erkennbar sind, aber beispielsweise die Störsicherheit verringern oder die Signallaufzeit erhöhen und damit beim Einsatz in einem System zu Ausfällen führen.

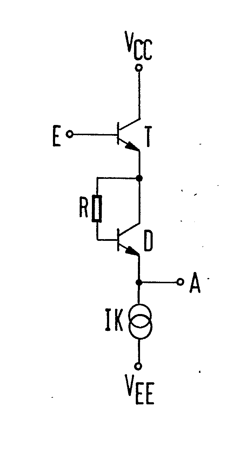

In Schaltungsanordnungen der CML-Technik, insbesondere der ECL- und $E^2$CL-Technik werden häufig als Dioden geschaltete Transistoren zur Pegelverschiebung benützt. (Vergl. "Der Fernmeldeingenieur", Juli 1973, Seite 20, Bild 13). Ist durch einen Fertigungsfehler der Kollektorkontakt nicht angeschlossen, dann bleibt noch die Basis-Emitter-Diode wirksam, aber mit einem um ca. 70 bis 130 mV erhöhten Spannungsabfall. Während nämlich im Normalfall der weit überwiegende Teil eines mindestens annähernd konstanten Stroms über die Kollektor-Emitter-Strecke des Transistors fließt und nur ein verschwindend kleiner Teil von der Basis übernommen wird, fließt im Fehlerfall der Gesamtstrom allein über die Basis-Emitter-Diode. Der gegen den Normalwert um einen falschen Betrag

She 1 Stl / 13.07.82

verschobene Pegel führt zu einer unsymmetrischen Ansteuerung eines nachgeschalteten Differenzverstärkers und damit zu einer einseitig verminderten Störsicherheit.

Der Erfindung liegt die Aufgabe zugrunde, integrierte Schaltungsanordnungen nach dem Prinzip der Stromumschaltetechnik so auszubilden, daß die Bausteine, die Fehler der vorstehend beschriebenen Art enthalten, durch die Überprüfung der statischen Ausgangssignale zuverlässig ermittelt und damit rechtzeitig ausgeschieden werden können. Gemäß der Erfindung wird diese Aufgabe durch das kennzeichnende Merkmal des Patentanspruchs gelöst.

Die Erfindung wird im folgenden anhand eines in der Zeichnung dargestellten Ausführungsbeispiels erläutert. Die Zeichnung zeigt eine Eingangsschaltung mit einem als Emitterfolger geschalteten Transistor T, an dessen Basis ein Eingangssignal E liegt, mit einer als Transistor ausgeführten Diode D, mit einer Konstantstromquelle IK und mit einem Ausgang A, der gewöhnlich mit dem Steuereingang eines Differenzverstärkers verbunden ist. Denkt man sich zunächst den Widerstand R kurzgeschlossen, dann werden solche Eingangsstufen zur Signalpegelverschiebung vorzugsweise bei ECL- und $E^2$CL-Schaltungen eingesetzt, die von dem Schaltungsprinzip Serienkopplung Gebrauch machen. Dioden zur Pegelverschiebung findet man aber auch beispielsweise in Hilfsschaltungen zur Erzeugung von Referenzspannungen und in Schaltungen zur Signalpegelanpassung beim Übergang von ECL- bzw. $E^2$CL-Schaltungen auf TTL-Schaltungen und umgekehrt. Hier sind vielfach auch mehrere Dioden in Serie geschaltet.

Ist durch einen Fertigungsfehler bei dem Ausführungsbeispiel gemäß der Zeichnung der Kollektor des als Diode D geschalteten Transistors nicht angeschlossen, dann fließt der ganze von der Konstanzstromquelle IK gelieferte Strom I durch den Widerstand R und erzeugt am Widerstand R einen zusätzlichen Spannungsabfall, der sich zum Spannungsabfall an der Basis-Emitter-Diode addiert. Der Wert des Widerstands R sollte so bemessen sein, daß der Spannungsabfall am Widerstand R größer als der halbe Signalhub ist, damit der Fehler durch die Überprüfung der statischen Ausgangssignale sicher feststellbar ist.

Im fehlerfreien Fall geht der Spannungsabfall am Widerstand R auf rund 1% des Wertes zurück, der im Fehlerfall entsteht, und spielt damit praktisch keine Rolle mehr. Darüber hinaus kann der geringe Einfluß auf den Betrag der Pegelverschiebung durch eine Anpassung maßgebender Referenzspannungen, beispielsweise der Referenzspannung eines angeschlossenen Differenzverstärkers kompensiert werden. Trotzdem empfiehlt es sich nicht, den im Störungsfall am Widerstand R entstehenden Spannungsabfall größer als den vollen Signalhub zu machen.

Der Widerstand R muß in einer Wanne angeordnet sein, die gegen den die Diode D bildenden Transistor isoliert ist. Anderenfalls würde zwischen dem Widerstand R und dem Transistor eine parasitäre Diode entstehen, die die beabsichtigte Wirkung stören würde.

1 Figur

1 Patentanspruch

<u>Patentanspruch</u>

Integrierte Schaltungsanordnung in Stromumschaltetechnik, bei der zum Zweck einer Pegelverschiebung ein als Transistor, dessen Basis mit dem Kollektor verbunden ist, ausgeführte, von einem mindestens annähernd konstanten Strom durchflossene Diode vorgesehen ist, d a d u r c h   g e k e n n z e i c h n e t , daß zwischen der Basis und dem Kollektor des die Diode (D) bildenden Transistors ein gegen den Transistor isolierter Widerstand (R) eingefügt ist, dessen Wert so bemessen ist, daß der mindestens annähernd konstante Strom (I) am Widerstand (R) einen Spannungsabfall erzeugen würde, der größer als der halbe und kleiner als der volle Signalhub ist.

1/1

**0099506**

Nummer der Anmeldung

**Europäisches Patentamt**

**EUROPÄISCHER RECHERCHENBERICHT**

EP 83 10 6520

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | IBM TECHNICAL DISCLOSURE BULLETIN, Band 21, Nr. 2, Juli 1978 F. MONTEGARI et al. "Array true-complement generator with power driver", Seiten 562, 563 * Figur * | 1 | H 03 K 19/003 H 03 K 19/086 |
| A | DE-B-2 404 637 (SIEMENS AG) * Figur 2 * | | |
| A | DE-A-3 006 176 (SIEMENS AG) * Figur 1 * | | |
| D,A | DER FERNMELDE-INGENIEUR, Band 27, Nr. 7, 15. Juli 1973, Bad Windsheim G. HANKE "ECL - Die Emitter-gekoppelte Logik", Seiten 19, 20 * Bild 13 * | | RECHERCHIERTE SACHGEBIETE (Int. Cl. ³) H 03 K 19/003 H 03 K 19/007 H 03 K 19/08 H 03 K 19/086 H 03 K 19/092 |

Der vorliegende Recherchenbericht wurde für alle Patentansprüche erstellt.

| Recherchenort | Abschlußdatum der Recherche | Prüfer |
|---|---|---|
| BERLIN | 25-08-1983 | ARENDT M |